# EUROPEAN PATENT SPECIFICATION

(11) **EP 3 270 496 B1**
(45) Date of publication and mention of the grant of the patent: **24.11.2021**
(21) Application number: 15884562.8
(22) Date of filing: 10.03.2015
(51) Int. Cl.: H02M 7/00, H05K 7/20, F24F 1/24

(54) **POWER CONVERSION DEVICE AND REFRIGERATION CYCLE DEVICE**
LEISTUNGSUMWANDLUNGSVORRICHTUNG UND KÜHLZYKLUSVORRICHTUNG
DISPOSITIF DE CONVERSION DE PUISSANCE ET DISPOSITIF A CYCLE FRIGORIFIQUE

(43) Date of publication of application: 17.01.2018
(73) Proprietor: Mitsubishi Electric Corporation, Chiyoda-ku Tokyo 100-8310 (JP)
(72) Inventor: TANIGUCHI, Yoshihiro, Tokyo 100-8310 (JP); KUSUBE, Shinsaku, Tokyo 100-8310 (JP); IWATA, Akihiko, Tokyo 100-8310 (JP); MURATA, Shinji, Tokyo 100-8310 (JP); TAKATA, Shigeo, Tokyo 100-8310 (JP)
(74) Representative: Pfenning, Meinig & Partner mbB
(86) International application number: PCT/JP2015/057019
(87) International publication number: WO 2016/143070

(56) References cited:
- EP-A1- 1 713 169
- EP-A1- 2 314 940
- JP-A- H03 242 997
- JP-A- H06 181 396
- JP-A- S62 131 550
- JP-A- 2008 070 016
- JP-A- 2011 242 078
- JP-A- 2014 096 957
- JP-A- 2014 122 724

## Description

### Technical Field

The present invention relates to a power conversion device including a power module and a refrigeration cycle apparatus including the power conversion device.

### Background Art

Refrigeration cycle apparatus such as air-conditioning apparatus and cooling and heating apparatus each include a compressor configured to compress refrigerant. Further, the refrigeration cycle apparatus each include, for example, a fan configured to send air with which refrigerant exchanges heat in a heat exchanger. Such a compressor and a fan are generally driven to rotate using an electric motor. Further, the operating state of the electric motor is precisely controlled using an inverter device, which is one of power conversion devices. While the inverter device is in operation, because a component of the inverter, for example, a power module generates heat, the inverter device is cooled to be prevented from reaching abnormally high temperature.

Patent Literature 1 discloses an air-conditioning apparatus in which a refrigerant jacket is fixed to an electrical circuit including a printed board and a power element (power module), via a heat transfer plate. The refrigerant jacket and the electrical circuit are connected to a refrigerant circuit through which refrigerant that is used for a refrigeration cycle circulates. Further, the refrigerant jacket has holes formed in the refrigerant jacket, and refrigerant pipes through which refrigerant circulates are inserted through the holes. This configuration of Patent Literature 1 is intended to transfer heat from the power element to refrigerant circulating through the refrigerant pipes.

Further, Patent Literature 2 discloses an air-conditioning apparatus in which a heat generating component (power module) and a heat transfer device are in close contact with each other. The heat transfer device is a multi-hole flat pipe through which whole refrigerant in a refrigerant circuit circulates, or a multi-hole flat pipe through which a part of refrigerant that is branched from the refrigerant circuit circulates. This configuration of Patent Literature 2 is intended to transfer heat from the heat generating component to refrigerant circulating through the heat transfer device. Document JP 2008 070016 A relates to an electrical equipment case body for receiving a circuit board on which electronic components are mounted in a sealed state. The body has a heat transfer base plate portion for heat radiation. This document does not disclose a heat rejection portion being fixed to a heat rejection surface of a power module, and the cooling panel being removably fixed to a surface of the heat rejection portion. Furthermore, document JPS62131550 A discloses a heat-sink attaching and detaching mechanism.

### Citation List

### Patent Literature

Patent Literature 1: Japanese Patent No. 4488093
Patent Literature 2: Japanese Unexamined Patent Application Publication No. 2014-122724

### Summary of Invention

### Technical Problem

However, the manufacturing cost of the air-conditioning apparatus disclosed in Patent Literature 1 is high because the refrigerant jacket is required to be subjected to processing for forming the holes through which the refrigerant pipes are inserted. Further, when service including replacement of the heat generating component (power module) is provided for the air-conditioning apparatus disclosed in Patent Literature 2, the heat generating component and the heat transfer device are separated from each other. In general, the heat generating component is mounted on a board via connection portions. Then, when the separated heat generating component is placed on a table, for example, loads such as the own weight of the heat generating component and external force are applied on the connection portion connecting the heat generating component and the board to each other. Thus, in the air-conditioning apparatus disclosed in Patent Literature 2, excessive loads are applied on the connection portion.

The present invention has been made in the context of the problems described above, and provides a power conversion device capable of reducing the manufacturing cost, and also reducing loads that are applied on a connection portion connecting a power module and a board to each other, and a refrigeration cycle apparatus including the power conversion device.

### Solution to Problem

According to one embodiment of the present invention, as defined by independent claim 1, a power conversion device includes a power module having a heat rejection surface, a board connected to the power module by a connection portion, and provided on a surface side opposite to the heat rejection surface of the power module, a casing accommodating the power module, a heat rejection portion fixed to the heat rejection surface of the power module, and configured to receive heat from the power module, a cooling panel removably fixed to a surface of the heat rejection portion opposite to a surface in contact with the power module, and configured to receive heat from the heat rejection portion, and a pipe fixed to a surface of the cooling panel opposite to a surface in contact with the heat rejection portion, and configured to transfer heat from the cooling panel to refrigerant circulating through the pipe. The heat rejection portion is mounted on the casing.

### Advantageous Effects of Invention

According to one embodiment of the present invention, the pipe is fixed to the cooling panel. Thus, the cooling panel is not required to be subjected to processing for forming the hole through which the pipe is inserted, and hence the manufacturing cost can be reduced. Further, the heat rejection portion is provided on the casing, and is removably fixed to the cooling panel. Thus, even when the heat rejection portion and the cooling panel are separated from each other in service including replacement of the power module, the power module is still fixed to the heat rejection portion provided on the casing. Consequently, loads such as the own weight of the power module and external force can be applied on the casing. As a result, excessive loads are not applied on the connection portion, and hence loads that are applied on the connection portion can be reduced.

### Brief Description of Drawings

[Fig. 1] Fig. 1 is a circuit diagram for illustrating a refrigeration cycle apparatus 1 according to Embodiment 1 of the present invention.
[Fig. 2] Fig. 2 is a front sectional view for illustrating a power conversion device 20 according to Embodiment 1 of the present invention.
[Fig. 3] Fig. 3 is a top view for illustrating the power conversion device 20 according to Embodiment 1 of the present invention.
[Fig. 4] Fig. 4 is a side view for illustrating a pipe 23 of the power conversion device 20 according to Embodiment 1 of the present invention.
[Fig. 5] Fig. 5 is a circuit diagram for illustrating a refrigeration cycle apparatus 1 according to a modification example of Embodiment 1 of the present invention.
[Fig. 6] Fig. 6 is a front sectional view for illustrating a power conversion device 20 according to Embodiment 2 of the present invention.
[Fig. 7] Fig. 7 is a front sectional view for illustrating a power conversion device 20 according to Embodiment 3 of the present invention.

### Description of Embodiments

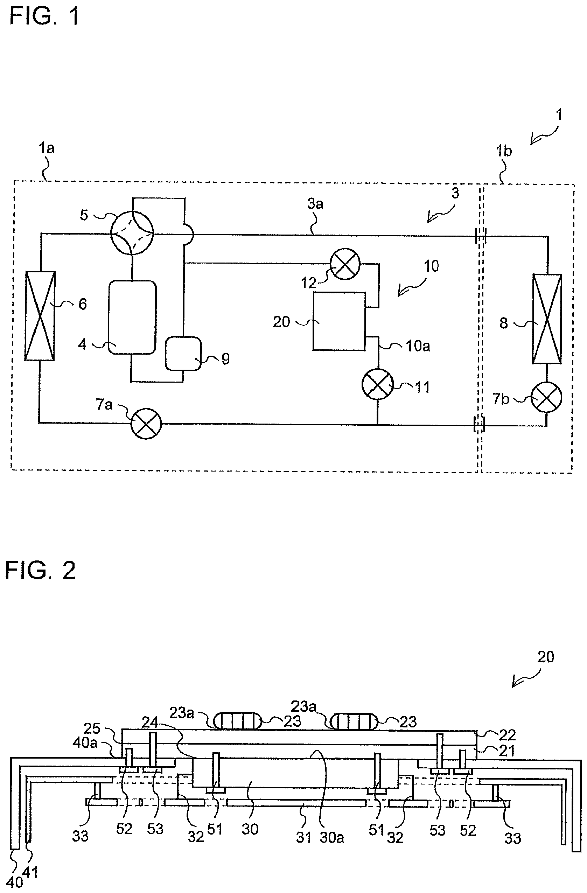

A power conversion device and a refrigeration cycle apparatus according to embodiments of the present invention are described with reference to the drawings. Note that, the present invention is not limited to the embodiments described below. Moreover, in the drawings referred to below including Fig. 1, the size relationship between components may be different from the reality in some cases.

### Embodiment 1

Fig. 1 is a circuit diagram for illustrating a refrigeration cycle apparatus 1 according to Embodiment 1 of the present invention. The refrigeration cycle apparatus 1 is described with reference to Fig. 1. As illustrated in Fig. 1, the refrigeration cycle apparatus 1 includes a power conversion device 20 and a refrigerant circuit 3. In addition, the refrigeration cycle apparatus 1 includes, for example, a bypass circuit 10. In Embodiment 1, an air-conditioning apparatus is exemplified as the refrigeration cycle apparatus 1, but the refrigeration cycle apparatus 1 may be a cooling and heating apparatus.

The refrigerant circuit 3 through which refrigerant circulates includes a compressor 4, a first heat exchanger 6, a first expansion device 7a, a second expansion device 7b, and a second heat exchanger 8 connected by a refrigerant pipe 3a. In addition, in the refrigerant circuit 3, for example, a four-way valve 5 and an accumulator 9 are connected to each other by the refrigerant pipe 3a. The refrigerant pipe 3a is, for example, a round pipe having a cylindrical shape.

The compressor 4 compresses refrigerant. The four-way valve 5 changes the circulation direction of refrigerant in the refrigerant circuit 3, and allows the refrigeration cycle apparatus 1 to perform both of cooling operation and heating operation. The first heat exchanger 6 exchanges heat between, for example, outdoor air and refrigerant. The first expansion device 7a and the second expansion device 7b expand and decompress refrigerant, and adjust the flow rate of refrigerant. The second heat exchanger 8 exchanges heat between, for example, indoor air and refrigerant. The accumulator 9 is provided on the suction side of the compressor 4, and accumulates, for example, surplus refrigerant due to a difference between the cooling operation and the heating operation.

The bypass circuit 10 is formed by connecting a point between the first expansion device 7a and the second expansion device 7b, and the suction side of the compressor 4 to each other by a bypass pipe 10a. Specifically, in the bypass circuit 10, the point between the first expansion device 7a and the second expansion device 7b, and the inflow side of the accumulator 9 are connected to each other by the bypass pipe 10a.

Further, the power conversion device 20 is configured such that refrigerant circulating between the first expansion device 7a and the second expansion device 7b flows into pipes 23 (see Fig. 2). Specifically, the power conversion device 20 is connected to the bypass pipe 10a of the bypass circuit 10. On the bypass pipe 10a, a first refrigerant adjusting device 11 and a second refrigerant adjusting device 12 are provided. Both of the first refrigerant adjusting device 11 and the second refrigerant adjusting device 12 each adjust the flow rate of refrigerant that circulates though the bypass pipe 10a. On the bypass pipe 10a, the power conversion device 20 is connected between the first refrigerant adjusting device 11 and the second refrigerant adjusting device 12. The bypass pipe 10a is, for example, a round pipe having a cylindrical shape. Further, the first refrigerant adjusting device 11 and the second refrigerant adjusting device 12 can be, for example, electronic expansion valves or capillary tubes.

The refrigeration cycle apparatus 1 includes, for example, an outdoor unit 1a and an indoor unit 1b, and the outdoor unit 1a accommodates the compressor 4, the four-way valve 5, the first heat exchanger 6, the first expansion device 7a, the accumulator 9, the power conversion device 20, the first refrigerant adjusting device 11, and the second refrigerant adjusting device 12. Further, the indoor unit 1b accommodates the second expansion device 7b and the second heat exchanger 8.

Fig. 2 is a front sectional view for illustrating the power conversion device 20 according to Embodiment 1 of the present invention. The power conversion device 20 is next described. As illustrated in Fig. 2, the power conversion device 20 includes a power module 30, a board 31, a casing 40, a heat rejection portion 21, a cooling panel 22, and the pipes 23. In addition, the power conversion device 20 includes, for example, an inner casing 41, a first heat transfer member 24, and a second heat transfer member 25.

The power module 30 has a heat rejection surface 30a. The heat rejection surface 30a is a surface for releasing lost heat of a semiconductor element, for example, an IGBT, an IPM, or a diode stack. In Embodiment 1, the heat rejection portion 21 is fixed directly to the heat rejection surface 30a of the power module 30. The power module 30 has two through holes viewable from the front. Through the two through holes, first screws 51 for fixing the power module 30 and the heat rejection portion 21 are inserted. The power module 30 and the heat rejection portion 21 are fixed by the first screws 51 screwed into screw holes in the heat rejection portion 21 through the through holes in the power module 30.

The board 31 is connected to the power module 30 by connection portions 32, and is provided on a surface side opposite to the heat rejection surface 30a of the power module 30. The board 31 has an electrical circuit, a microcomputer, an IC, and other components formed on the board 31. Further, the board 31 has holes formed in the board 31 through which the first screws 51, second screws 52, and third screws 53 are inserted. The second screws 52 fix the heat rejection portion 21 and the casing 40 accommodating the power module 30. Further, the third screws 53 fix the heat rejection portion 21 and the cooling panel 22. The electrical circuit, the microcomputer, the IC, and other components formed on the board 31 control the operating state of an electric motor that is used for the compressor 4, a fan (not shown), and other components, determine an abnormal stop of the refrigeration cycle apparatus 1, and communicate with other air-conditioning apparatus and cooling and heating apparatus.

Further, the electrical circuit, the microcomputer, the IC, and other components formed on the board 31 may control the first expansion device 7a, the second expansion device 7b, the first refrigerant adjusting device 11, and the second refrigerant adjusting device 12. In this case, the electrical circuit, the microcomputer, the IC, and other components formed on the board 31 adjust the opening degrees of the first expansion device 7a, the second expansion device 7b, the first refrigerant adjusting device 11, and the second refrigerant adjusting device 12 depending on an amount of heat generated by the power module 30. With this configuration, the flow rate of refrigerant is adjusted. An amount of heat generated by the power module 30 may be measured by a temperature detecting unit built in the power module 30, or a temperature detecting unit provided in the vicinity of the power module 30. In addition, an amount of heat generated by the power module 30 may be computed on the basis of information on current and voltage used in control of the motor, for example. In this case, no temperature detecting unit is provided.

The connection portions 32 are, for example, power module terminals. The connection portions 32 may be substituted with screw terminals in a strong voltage part, and connectors in a weak voltage part, for example.

The casing 40 accommodates the power module 30. The casing 40 has an opening in which the power module 30 and the heat rejection portion 21 are in contact with each other. Further, a sealing member 40a is provided between the heat rejection portion 21 and the casing 40. The sealing member 40a has a shape along the rim portion of the heat rejection portion 21. The sealing member 40a prevents water from entering between the heat rejection portion 21 and the casing 40 when the power conversion device 20 is provided in an environment in which the power conversion device 20 is exposed to moisture. With the sealing member 40a, the power module 30 accommodated in the casing 40 is prevented from being contaminated with water.

The casing 40 has four through holes viewable from the front. Through the two through holes among the four through holes, the second screws 52 for fixing the casing 40 and the heat rejection portion 21 are inserted. Further, through the remaining two through holes, the third screws 53 for fixing the heat rejection portion 21 and the cooling panel 22 are inserted.

The inner casing 41 is provided inside the casing 40, and accommodates the power module 30 together with the casing 40. Thus, the power module 30 is accommodated in a double structure including the casing 40 and the inner casing 41 to prevent condensation and entrance of water. The board 31 is connected to the inner casing 41 via spacers 33. The spacers 33 are made of, for example, metal, resin, or both of metal and resin. When the inner casing 41 is omitted, the board 31 is connected to the casing 40 via the spacers 33.

The heat rejection portion 21 is fixed to the heat rejection surface 30a of the power module 30, and receives heat from the power module 30. The heat rejection portion 21 is provided on the casing 40. In Embodiment 1, the heat rejection portion 21 is a heat rejection panel that is independent of the casing 40. The heat rejection portion 21 is made of a material having high heat conductivity, for example, aluminum or copper. Further, electrolytic corrosion is prevented when the heat rejection portion 21 is made of the same material as, for example, the cooling panel 22. The power module 30 is made of a material, for example, copper or plated copper. Thus, electrolytic corrosion due to contact between the power module 30 and the heat rejection portion 21 may be prevented by subjecting the heat rejection portion 21 to surface treatment, for example, alumite treatment.

The heat rejection portion 21 has four screw holes and two through holes viewable from the front. Into the two screw holes among the four screw holes, the first screws 51 for fixing the power module 30 and the heat rejection portion 21 are screwed. Further, into the remaining two screw holes, the second screws 52 for fixing the heat rejection portion 21 and the casing 40 accommodating the power module 30 are screwed. In addition, through the two through holes, the third screws 53 for fixing the heat rejection portion 21 and the cooling panel 22 are inserted.

The casing 40 and the heat rejection portion 21 are fixed by the second screws 52 screwed into the screw holes in the heat rejection portion 21 through the through holes in the casing 40. Further, the casing 40, the heat rejection portion 21, and the cooling panel 22 are fixed by the third screws 53 screwed into the screw holes in the cooling panel 22 through the through holes in the casing 40 and the through holes in the heat rejection portion 21. Thus, the cooling panel 22 is removably fixed to the casing 40 and sandwiches the heat rejection portion 21 together with the casing 40.

The cooling panel 22 is removably fixed to a surface of the heat rejection portion 21 opposite to the surface in contact with the power module 30, and receives heat from the heat rejection portion 21. The cooling panel 22 is made of a material having high heat conductivity, for example, aluminum or copper. The material of the cooling panel 22 is appropriately changed depending on a material of the pipes 23 that are brazed to the cooling panel 22, for example. Further, electrolytic corrosion is prevented when the cooling panel 22 is made of the same material as, for example, the heat rejection portion 21.

Further, the heat rejection portion 21 has a thermal resistance larger than the thermal resistance of the cooling panel 22. Thus, an amount of heat transferred from the heat rejection portion 21 to the cooling panel 22 is larger than an amount of heat transferred from the power module 30 to the heat rejection portion 21. This prevents the power module 30 from being cooled abruptly. Consequently, condensation on the power module 30 and the connection portions 32 is prevented. Further, the cooling panel 22 has a size equal to or larger than the size of the heat rejection portion 21, and especially in Embodiment 1, the cooling panel 22 has the same size as the heat rejection portion 21.

The cooling panel 22 has two screw holes viewable from the front. Into the two screw holes, the third screws 53 for fixing the heat rejection portion 21 and the cooling panel 22 are screwed.

The pipes 23 are fixed to a surface of the cooling panel 22 opposite to the surface in contact with the heat rejection portion 21, and transfer heat from the cooling panel 22 to refrigerant circulating through the pipes 23. The pipes 23 are, for example, flat pipes flattened in a vertical direction when the pipes are viewed from the front, and have a plurality of holes formed in each of the pipes 23 through which refrigerant circulates. The pipes 23 are made of a material having high heat conductivity, for example, aluminum or copper. Excellent brazability is achieved and electrolytic corrosion is prevented when the pipes 23 are made of the same material as the cooling panel 22 to which the pipes 23 are brazed, for example. Further, through brazing between the pipes 23 and the cooling panel 22, the thermal resistance can be reduced. Thus, the pipes 23 and the cooling panel 22 are in contact with each other by brazing portions 23a.

The pipes 23 and the cooling panel 22 may be bonded to each other via a heat transfer member having a high heat transfer property, for example. In this case, the manufacturing cost can be reduced. Further, the cooling panel 22 may have grooves (not shown) into which the pipes 23 are press-fitted. The grooves have a width slightly shorter than the width of the pipes 23, and a depth substantially equal to the height of the pipes 23. The heat transfer property can be improved by press-fitting the pipes 23 into the grooves in the cooling panel 22 to directly fix the pipes 23 and the cooling panel 22.

Further, in the case exemplified in Fig. 1, the number of pipes 23 is two, but the number of pipes 23 may be three or more, or one. In the case of using one pipe 23, the manufacturing process of the power conversion device 20 can be simplified. Further, in the case of using a plurality of pipes 23, the power module 30 can be properly cooled even when the heat rejection area of the power module 30 is large.

In addition, in the case of using a plurality of pipes 23, two-pass channels, one-way channels, or a combination of two-pass channels and one-way channels can be appropriately selected by changing the number of pipes 23 and a connection method of the pipes 23 depending on a lost heat amount of the power module 30. The pipe 23 of the two-pass channels is achieved by connecting the destination end portion of a forward path and the start end portion of a return path to each other by a U-bend pipe. In addition, change in the heat rejection area of the power module 30 can also be dealt with by widening the pipe 23 in a width direction to increase an area in which the pipe 23 is in contact with the cooling panel 22, irrespective of the number of the pipes 23.

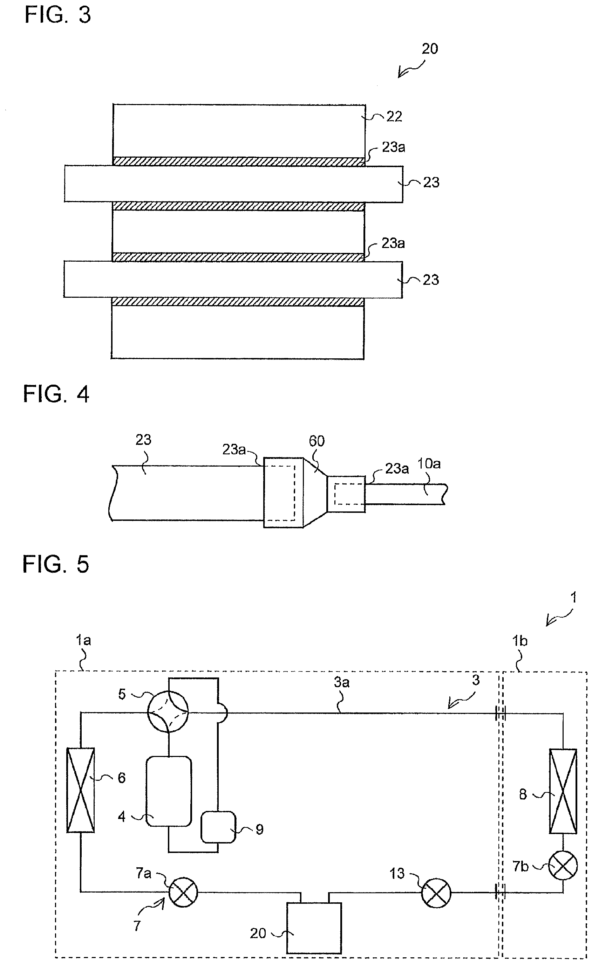

Fig. 3 is a top view for illustrating the power conversion device 20 according to Embodiment 1 of the present invention, and Fig. 4 is a side view for illustrating the pipe 23 of the power conversion device 20 according to Embodiment 1 of the present invention. As illustrated in Fig. 3, the pipes 23 protrude from the rim portion of the cooling panel 22. As illustrated in Fig. 4, the pipe 23 is connected to the bypass pipe 10a by a joint 60. The joint 60 is made of a material having high heat conductivity, for example, aluminum or copper, and is a member connecting a flat pipe and a round pipe to each other. The pipe 23 and the joint 60 are brazed in a brazing portion 23a between the pipe 23 and the joint 60. Further, the bypass pipe 10a and the joint 60 are brazed in a brazing portion 23a between the bypass pipe 10a and the joint 60.

As described above, the pipe 23 is a flat pipe and the bypass pipe 10a is a round pipe. The pipe 23, which is a flat pipe, is brazed to one end of the joint 60, and the bypass pipe 10a, which is a round pipe, is brazed to the other end of the joint 60. Further, electrolytic corrosion is prevented when the joint 60 is made of the same material as, for example, the pipe 23 and the bypass pipe 10a. In Embodiment 1, the pipes 23 protrude from the rim portion of the cooling panel 22, and hence the pipes 23 connected to the joints 60 can be directly heated. Thus, the pipes 23 are easily brazed. The joint 60 is not limited to the member connecting a flat pipe and a round pipe to each other, and may be appropriately changed to, for example, a member connecting a flat pipe and a flat pipe to each other, depending on the shape of each pipe.

The first heat transfer member 24 is interposed between the power module 30 and the heat rejection portion 21. The first heat transfer member 24 is filled into a gap between the power module 30 and the heat rejection portion 21 so that heat is efficiently transferred from the power module 30 to the heat rejection portion 21. The first heat transfer member 24 is, for example, a heat rejection sheet, a heat conductive sheet, or heat rejection grease. When the power module 30 and the heat rejection portion 21 are in close contact with each other and the thermal resistance is sufficiently small, the first heat transfer member 24 may be omitted.

The second heat transfer member 25 is interposed between the heat rejection portion 21 and the cooling panel 22. The second heat transfer member 25 is filled into a gap between the heat rejection portion 21 and the cooling panel 22 so that heat is efficiently transferred from the heat rejection portion 21 to the cooling panel 22. The second heat transfer member 25 is, for example, a heat rejection sheet, a heat conductive sheet, or heat rejection grease. When the heat rejection portion 21 and the cooling panel 22 are in close contact with each other and the thermal resistance is sufficiently small, the second heat transfer member 25 may be omitted.

The first heat transfer member 24 has a thermal resistance larger than the thermal resistance of the second heat transfer member 25. In the power conversion device 20, condensation may be formed on the power module 30 due to refrigerant circulating through the pipes 23. In Embodiment 1, the first heat transfer member 24 has a thermal resistance larger than the thermal resistance of the second heat transfer member 25, and hence an amount of heat transferred from the heat rejection portion 21 to the cooling panel 22 is larger than an amount of heat transferred from the power module 30 to the heat rejection portion 21. This prevents the power module 30 from being cooled abruptly. Consequently, condensation on the power module 30 is prevented. The thermal resistances of the first heat transfer member 24 and the second heat transfer member 25 may be changed by changing the materials of the members, or changing the thicknesses of the members.

The first heat transfer member 24 may have a thermal resistance smaller than the thermal resistance of the second heat transfer member 25. In this case, an amount of heat transferred from the heat rejection portion 21 to the cooling panel 22 is smaller than an amount of heat transferred from the power module 30 to the heat rejection portion 21. This prevents the pipes 23 in contact with the cooling panel 22 from being cooled abruptly. Consequently, condensation on the pipes 23 is prevented. The thermal resistances of the first heat transfer member 24 and the second heat transfer member 25 may be changed by changing the materials of the members, or changing the thicknesses of the members.

Next, the operation of the refrigeration cycle apparatus 1 is described. First, the cooling operation is described. In the cooling operation, the discharge side of the compressor 4 and the first heat exchanger 6 are connected to each other at the four-way valve 5 (solid line in Fig. 1). The compressor 4 sucks refrigerant and compresses the refrigerant to discharge the refrigerant in a high-temperature and high-pressure gas state. The discharged refrigerant flows into the first heat exchanger 6 through the four-way valve 5, and the first heat exchanger 6 condenses the refrigerant through heat exchange with outdoor air. The condensed refrigerant flows into the first expansion device 7a, and the first expansion device 7a expands and decompresses the condensed refrigerant.

Then, a part of the decompressed refrigerant flows into the second expansion device 7b, and the second expansion device 7b further expands and decompresses the decompressed refrigerant. Then, the decompressed refrigerant, which turns into two-phase gas-liquid refrigerant, flows into the second heat exchanger 8, and the second heat exchanger 8 evaporates the refrigerant through heat exchange with indoor air. The indoor air is cooled at this time, and an indoor space is cooled as a result. Then, the refrigerant, which turns into refrigerant in a high-temperature and low-pressure gas state through evaporation, flows into the accumulator 9 through the four-way valve 5 to be sucked by the compressor 4.

On the other hand, the other part of the refrigerant decompressed by the first expansion device 7a flows into the bypass circuit 10. The refrigerant that flowed into the bypass circuit 10 flows into the first refrigerant adjusting device 11, and the first refrigerant adjusting device 11 adjusts the flow rate of the refrigerant so that the refrigerant has low temperature and low pressure. Then, the refrigerant having passed through the first refrigerant adjusting device 11 circulates through the pipes 23 of the power conversion device 20. At this time, the refrigerant circulating through the pipes 23 is heated by heat transferred from the power module 30 via the pipes 23 and other components. Then, the heated refrigerant flows into the second refrigerant adjusting device 12, and the second refrigerant adjusting device 12 adjusts the flow rate of the refrigerant. Subsequently, the refrigerant flows into the accumulator 9 to be sucked by the compressor 4.

Next, the heating operation is described. In the heating operation, the discharge side of the compressor 4 and the second heat exchanger 8 are connected to each other at the four-way valve 5 (broken line in Fig. 1). The compressor 4 sucks refrigerant and compresses the refrigerant to discharge the refrigerant in a high-temperature and high-pressure gas state. The discharged refrigerant flows into the second heat exchanger 8 through the four-way valve 5, and the second heat exchanger 8 condenses the refrigerant through heat exchange with indoor air. The indoor air is heated at this time, and the indoor space is heated as a result. The condensed refrigerant flows into the second expansion device 7b, and the second expansion device 7b expands and decompresses the condensed refrigerant.

Then, a part of the decompressed refrigerant flows into the first expansion device 7a, and the first expansion device 7a further expands and decompresses the decompressed refrigerant. Then, the decompressed refrigerant, which turns into two-phase gas-liquid refrigerant, flows into the first heat exchanger 6, and the first heat exchanger 6 evaporates the refrigerant through heat exchange with outdoor air. Then, the refrigerant, which turns into refrigerant in a high-temperature and low-pressure gas state through evaporation, flows into the accumulator 9 through the four-way valve 5 to be sucked by the compressor 4.

On the other hand, the other part of the refrigerant decompressed by the second expansion device 7b flows into the bypass circuit 10. The refrigerant that flowed into the bypass circuit 10 flows into the first refrigerant adjusting device 11, and the first refrigerant adjusting device 11 adjusts the flow rate of the refrigerant so that the refrigerant have low temperature and low pressure. Then, the refrigerant having passed through the first refrigerant adjusting device 11 circulates through the pipes 23 of the power conversion device 20. At this time, the refrigerant circulating through the pipes 23 is heated by heat transferred from the power module 30 via the pipes 23 and other components. Then, the heated refrigerant flows into the second refrigerant adjusting device 12, and the second refrigerant adjusting device 12 adjusts the flow rate of the refrigerant. Subsequently, the refrigerant flows into the accumulator 9 to be sucked by the compressor 4.

Next, the action of the power conversion device 20 according to Embodiment 1 is described. Lost heat of the power module 30, which is generated while the refrigeration cycle apparatus 1 is operating, is transferred through the heat rejection portion 21, the cooling panel 22, and the pipes 23 in the stated order to be recovered by refrigerant circulating through the pipes 23. In the power conversion device 20, the pipes 23 are fixed to the cooling panel 22. Thus, the cooling panel 22 is not required to be subjected to processing for forming holes through which the pipes 23 are inserted, and hence the manufacturing cost can be reduced.

Further, the heat rejection portion 21 is provided on the casing 40, and is removably fixed to the cooling panel 22. Thus, even when the heat rejection portion 21 and the cooling panel 22 are separated from each other in service including replacement of the power module 30, the power module 30 is still fixed to the heat rejection portion 21 provided on the casing 40. Consequently, loads such as the own weight of the power module 30 and external force can be applied on the casing 40. As a result, excessive loads are not applied on the connection portions 32, and hence loads that are applied on the connection portions 32 can be reduced. This is advantageous also in manufacture in addition to the service. Further, the above-mentioned operation may be performed when the refrigeration cycle apparatus 1 is stopped. In Embodiment 1, the heat rejection portion 21 and the cooling panel 22 are separated from each other by releasing the third screws 53.

Further, the cooling panel 22 has a size equal to or larger than the size of the heat rejection portion 21. Thus, heat transferred from the power module 30 to the heat rejection portion 21 is transferred from the entire surface of the heat rejection portion 21 to the cooling panel 22. Consequently, the heat transfer property can be improved. In addition, the cooling panel 22 has the same size as the size of the heat rejection portion 21. Thus, the size of the heat rejection portion 21 can be reduced as much as possible while the heat transfer property is maintained. Consequently, the manufacturing cost can be reduced.

In addition, the pipes 23 are provided on the other side surface of the cooling panel 22 and protrude from the rim of the cooling panel 22. Thus, when the joints 60 are brazed to the pipes 23, the pipes 23 connected to the joints 60 can be directly heated. Consequently, the pipes 23 are easily brazed. In a conventional air-conditioning apparatus in which a refrigerant jacket is fixed to an electrical circuit including a printed board and a power element (power module), via a heat transfer plate, the refrigerant jacket has a recessed processed surface through a hole forming process. Thus, when joints are brazed to pipes, the pipes cannot be directly heated and are difficult to be brazed.

In addition, the heat rejection portion 21 has a thermal resistance larger than the thermal resistance of the cooling panel 22. Thus, an amount of heat transferred from the heat rejection portion 21 to the cooling panel 22 is larger than an amount of heat transferred from the power module 30 to the heat rejection portion 21. This prevents the power module 30 from being cooled abruptly. Consequently, condensation on the power module 30 is prevented.

Further, the first heat transfer member 24 has a thermal resistance larger than the thermal resistance of the second heat transfer member 25. In the power conversion device 20, condensation may be formed on the power module 30 due to refrigerant circulating through the pipes 23. In Embodiment 1, the first heat transfer member 24 has a thermal resistance larger than the thermal resistance of the second heat transfer member 25, and hence an amount of heat transferred from the heat rejection portion 21 to the cooling panel 22 is larger than an amount of heat transferred from the power module 30 to the heat rejection portion 21. This prevents the power module 30 from being cooled abruptly. Consequently, condensation on the power module 30 and the connection portions 32 is prevented.

The first heat transfer member 24 may have a thermal resistance smaller than the thermal resistance of the second heat transfer member 25. In this case, an amount of heat transferred from the heat rejection portion 21 to the cooling panel 22 is smaller than an amount of heat transferred from the power module 30 to the heat rejection portion 21. This prevents the pipes 23 in contact with the cooling panel 22 from being cooled abruptly.

Further, in Embodiment 1, heat from the power module 30 is transferred to, of refrigerant circulating through the refrigerant circuit 3, refrigerant that flowed into the bypass circuit 10, in short, a part of refrigerant circulating through the refrigerant circuit 3. Thus, adjustment of the temperature of refrigerant for heat rejection is required only in the bypass circuit 10. Consequently, the temperature of refrigerant can be precisely adjusted.

Further, the power conversion device 20 is provided, on the bypass circuit 10, between the first refrigerant adjusting device 11 and the second refrigerant adjusting device 12. Thus, refrigerant that flows through the pipes 23 of the power conversion device 20 has an intermediate pressure. The amount of temperature decrease in the power conversion device 20 can be appropriately adjusted by adjusting the opening degrees of the first refrigerant adjusting device 11 and the second refrigerant adjusting device 12, corresponding to the operating state of the refrigeration cycle apparatus 1 or lost heat (heat of evaporation) of the power module 30.

One of the first refrigerant adjusting device 11 and the second refrigerant adjusting device 12 may be omitted. In this case, the cost can be reduced. In the case of omitting the second refrigerant adjusting device 12, the first refrigerant adjusting device 11 expands refrigerant so that the refrigerant has low temperature and low pressure, and causes the refrigerant to flow into the pipes 23 of the power conversion device 20. Thus, lost heat of the power module 30 can be recovered by the refrigerant circulating through the pipes 23 (the power module 30 can be cooled).

On the other hand, in the case of omitting the first refrigerant adjusting device 11, refrigerant circulating through the pipes 23 of the power conversion device 20 is high-pressure liquid refrigerant generally having a temperature of from 30°C to 60°C. Depending on a load, the power module 30 generates heat up to 100°C or more due to lost heat in many cases, and has a higher temperature than the high-pressure liquid refrigerant. Thus, lost heat of the power module 30 can be recovered by the refrigerant circulating through the pipes 23 (the power module 30 can be cooled). Further, an amount of heat that is recovered by the refrigerant can be controlled by adjusting the flow rate of the refrigerant through adjustment of the opening degree of the second refrigerant adjusting device 12.

A refrigeration cycle apparatus has been known in which a heatsink is mounted on a controller including an inverter device that is provided with a power module and other components. The heat rejection surface of the component forming the inverter device of the controller is in close contact with the heatsink. In this case, the heatsink is required, and the lowest temperature to be achieved by cooling is a temperature at a location in which the refrigeration cycle apparatus is provided. Further, the size and shape of the heatsink are required to be changed depending on an amount of heat of the inverter device. In addition, forcible air cooling by a cooling fan is required. In contrast to this configuration, Embodiment 1 has the above-mentioned configuration, and hence no heatsink is required. Further, a temperature can be reduced by cooling to be equal to or lower than a temperature at a location in which the refrigeration cycle apparatus 1 is provided, and no cooling fan is required.

### (Modification Example)

Next, a refrigeration cycle according to a modification example of Embodiment 1 is described. Fig. 5 is a circuit diagram for illustrating a refrigeration cycle apparatus 1 according to the modification example of Embodiment 1 of the present invention. As illustrated in Fig. 5, the refrigeration cycle apparatus 1 differs from that of Embodiment 1 in that the bypass circuit 10 is not included. The pipes 23 of the power conversion device 20 are connected to the refrigerant pipe 3a connecting the first expansion device 7a and the second expansion device 7b to each other.

A third refrigerant adjusting device 13 is provided between the power conversion device 20 and the second expansion device 7b. The third refrigerant adjusting device 13 adjusts the flow rate of refrigerant that circulates through the refrigerant pipe 3a. The third refrigerant adjusting device 13 can be, for example, an electronic expansion valve or a capillary tube. The third refrigerant adjusting device 13 or the second expansion device 7b may be omitted. In this case, the cost can be reduced.

Next, the operation of the refrigeration cycle apparatus 1 is described. First, the cooling operation is described. In the cooling operation, the discharge side of the compressor 4 and the first heat exchanger 6 are connected to each other at the four-way valve 5 (solid line in Fig. 5). The compressor 4 sucks refrigerant and compresses the refrigerant to discharge the refrigerant in a high-temperature and high-pressure gas state. The discharged refrigerant flows into the first heat exchanger 6 through the four-way valve 5, and the first heat exchanger 6 condenses the refrigerant through heat exchange with outdoor air. The condensed refrigerant flows into the first expansion device 7a, and the first expansion device 7a expands and decompresses the condensed refrigerant.

Then, the decompressed refrigerant, which turns into low-temperature and low-pressure refrigerant, circulates through the pipes 23 of the power conversion device 20. At this time, the refrigerant circulating through the pipes 23 is heated by heat transferred from the power module 30 via the pipes 23 and other components. Then, the heated refrigerant flows into the third refrigerant adjusting device 13, and the third refrigerant adjusting device 13 adjusts the flow rate of the refrigerant so that the refrigerant has low temperature and low pressure. Then, the refrigerant having passed through the third refrigerant adjusting device 13 flows into the second expansion device 7b, and the second expansion device 7b expands and decompresses the refrigerant. Then, the decompressed refrigerant, which turns into two-phase gas-liquid refrigerant, flows into the second heat exchanger 8, and the second heat exchanger 8 evaporates the refrigerant through heat exchange with indoor air. The indoor air is cooled at this time, and the indoor space is cooled as a result. Then, the refrigerant, which turns into refrigerant in a high-temperature and low-pressure gas state through evaporation, flows into the accumulator 9 through the four-way valve 5 to be sucked by the compressor 4.

Next, the heating operation is described. In the heating operation, the discharge side of the compressor 4 and the second heat exchanger 8 are connected to each other at the four-way valve 5 (broken line in Fig. 5). The compressor 4 sucks refrigerant and compresses the refrigerant to discharge the refrigerant in a high-temperature and high-pressure gas state. The discharged refrigerant flows into the second heat exchanger 8 through the four-way valve 5, and the second heat exchanger 8 condenses the refrigerant through heat exchange with indoor air. The indoor air is heated at this time, and the indoor space is heated as a result. The condensed refrigerant flows into the second expansion device 7b, and the second expansion device 7b expands and decompresses the condensed refrigerant. Then, the decompressed refrigerant flows into the third refrigerant adjusting device 13, and the third refrigerant adjusting device 13 adjusts the flow rate of the refrigerant so that the refrigerant has low temperature and low pressure.

Then, the refrigerant having passed through the third refrigerant adjusting device 13 circulates through the pipes 23 of the power conversion device 20. At this time, the refrigerant circulating through the pipes 23 is heated by heat transferred from the power module 30 via the pipes 23 and other components. Then, the heated refrigerant flows into the first expansion device 7a, and the first expansion device 7a expands and decompresses the condensed refrigerant. Then, the decompressed refrigerant, which turns into two-phase gas-liquid refrigerant, flows into the first heat exchanger 6, and the first heat exchanger 6 evaporates the refrigerant through heat exchange with outdoor air. Then, the refrigerant, which turns into refrigerant in a high-temperature and low-pressure gas state through evaporation, flows into the accumulator 9 through the four-way valve 5 to be sucked by the compressor 4.

In the modification example, heat from the power module 30 is transferred to whole refrigerant circulating through the refrigerant circuit 3. Thus, even when the bypass circuit 10 in Embodiment 1 is omitted, the same effect as that of Embodiment 1 is provided. Further, the first refrigerant adjusting device 11 and the second refrigerant adjusting device 12 can be omitted because the third refrigerant adjusting device 13 is provided instead, and hence the cost can be reduced.

Further, the power conversion device 20 is provided between the first expansion device 7a and the third refrigerant adjusting device 13 in the refrigerant circuit 3. Thus, refrigerant that flows through the pipes 23 of the power conversion device 20 has an intermediate pressure. The amount of temperature decrease in the power conversion device 20 can be appropriately adjusted by adjusting the opening degrees of the first expansion device 7a and the third refrigerant adjusting device 13, corresponding to the operating state of the refrigeration cycle apparatus 1 or lost heat (heat of evaporation) of the power module 30.

### Embodiment 2

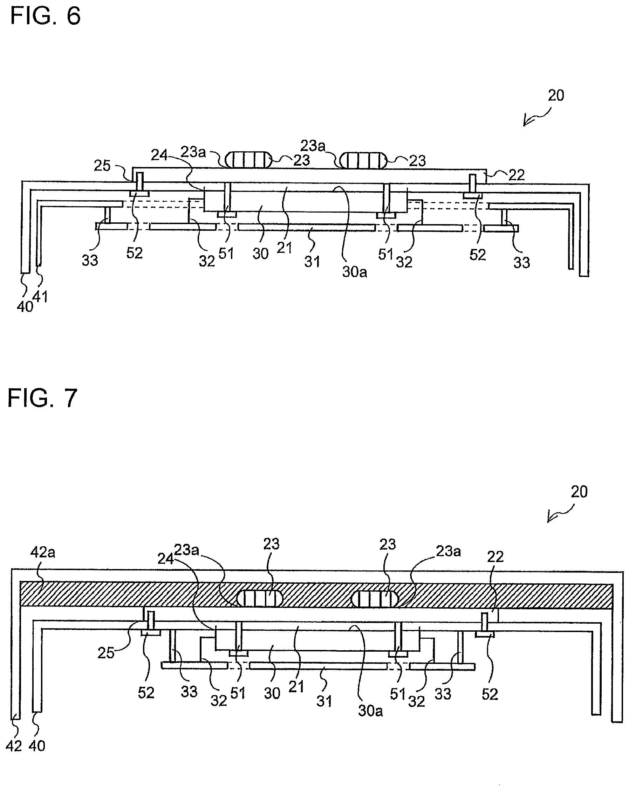

Next, a power conversion device 20 according to Embodiment 2 of the present invention is described. Fig. 6 is a front sectional view for illustrating the power conversion device 20 according to Embodiment 2 of the present invention. Embodiment 2 differs from Embodiment 1 in that the heat rejection portion 21 is integrated with the casing 40. In Embodiment 2, the same parts as those of Embodiment 1 are denoted by the same reference signs to omit description of the same parts, and the difference from Embodiment 1 is mainly described.

As illustrated in Fig. 6, the heat rejection portion 21 is integrated with the casing 40. That is, a heat rejection panel corresponding to the heat rejection portion 21 of Embodiment 1 is omitted, and the casing 40 has a function of the heat rejection panel. Thus, Embodiment 2, in which the heat rejection panel is omitted, can provide the same effect as Embodiment 1 and further reduce the manufacturing cost. Further, the third screws 53 of Embodiment 1, that is, the third screws 53 for fixing the heat rejection portion 21 (heat rejection panel) and the cooling panel 22 in Embodiment 1 can be omitted. Thus, the manufacturing cost can be further reduced. In addition, the board 31 is not required to have the holes through which the third screws 53 are inserted, and hence the effective area of the board 31 can be increased. This can reduce limitations on a board pattern artwork design.

The power conversion device 20 according to Embodiment 2 can be applied to the refrigeration cycle apparatus 1 of Embodiment 1 (see Fig. 1), and further to the refrigeration cycle apparatus 1 of the modification example of Embodiment 1 as well (see Fig. 5).

### Embodiment 3

Next, a power conversion device 20 according to Embodiment 3 of the present invention is described. Fig. 7 is a front sectional view for illustrating the power conversion device 20 according to Embodiment 3 of the present invention. Embodiment 3 differs from Embodiment 2 in that the power conversion device 20 includes an outer casing 42. In Embodiment 3, the same parts as those of Embodiments 1 and 2 are denoted by the same reference signs to omit description of the same parts, and the difference from Embodiments 1 and 2 is mainly described.

As illustrated in Fig. 7, the power conversion device 20 includes the outer casing 42. The outer casing 42 covers the casing 40, the heat rejection portion 21, the cooling panel 22, and the pipes 23, and has a heat insulating material 42a inside the outer casing 42. The heat insulating material 42a can be made of a material changeable in form to fit the shapes of the pipes 23 and the cooling panel 22. This can reduce an air layer between the heat insulating material 42a, and the cooling panel 22 and the pipes 23 as much as possible, thereby preventing heat transferred to the casing 40 from being diffused to parts other than the cooling panel 22.

Further, in Embodiment 3, the inner casing 41 is omitted and the board 31 is mounted on the casing 40 via the spacers 33.

Thus, in Embodiment 3, the heat insulating material 42a is provided between the outer casing 42, and the cooling panel 22 and the pipes 23. Thus, the cooling energy of refrigerant circulating through the pipes 23 does not leak beyond the outer casing 42. Consequently, heat generated by the power module 30 can be effectively cooled. Further, the cooling energy of the refrigerant circulating through the pipes 23 slightly leaks to be maintained between the heat insulating material 42a, the cooling panel 22, and casing 40, and hence the whole casing 40 can be cooled. As a result, a temperate in the casing 40 is decreased, allowing increase in acceptable temperature rating of the power module 30 accommodated in the casing 40.

Further, in Embodiment 3, the inner casing 41 is omitted and the board 31 is mounted on the casing 40 via the spacers 33. Thus, because the inner casing 41 is omitted, the manufacturing cost can be reduced. Further, the board 31 is not required to have the holes through which the second screws 52 are inserted, and hence the effective area of the board 31 can be increased. This can reduce limitations on a board pattern artwork design.

The power conversion device 20 according to Embodiment 3 can be applied to the refrigeration cycle apparatus 1 of Embodiment 1 (see Fig. 1), and further to the refrigeration cycle apparatus 1 of the modification example of Embodiment 1 as well (see Fig. 5). Further, Embodiment 3 may include the heat rejection portion 21 (heat rejection panel) of the power conversion device 20 according to Embodiment 1. In addition, Embodiment 3 may include the inner casing 41 of the power conversion device 20 according to Embodiment 1 or 2.

### Reference Signs List

1 refrigeration cycle apparatus 1a outdoor unit 1b indoor unit 3 refrigerant circuit 3a refrigerant pipe 4 compressor 5 four-way valve 6 first heat exchanger 7a first expansion device 7b second expansion device 8 second heat exchanger 9 accumulator 10 bypass circuit 10a bypass pipe 11 first refrigerant adjusting device 12 second refrigerant adjusting device 13 third refrigerant adjusting device 20 power conversion device 21 heat rejection portion 22 cooling panel 23 pipe 23a brazing portion 24 first heat transfer member 25 second heat transfer member 30 power module30a heat rejection surface 31 board 32 connection portion 33 spacer 40 casing 40a sealing member 41 inner casing 42 outer casing 42a heat insulating material 51 first screw 52 second screw 53 third screw 60 joint

## Claims

1. A power conversion device (20), comprising:
a power module (30) having a heat rejection surface (30a);
a board (31) connected to the power module (30) by a connection portion (32), and provided on a surface side opposite to the heat rejection surface (30a) of the power module (30);
a casing (40) accommodating the power module (30);
a heat rejection portion (21) fixed to the heat rejection surface (30a) of the power module (30), and configured to receive heat from the power module (30);
a cooling panel (22) removably fixed to a surface of the heat rejection portion (21) opposite to a surface in contact with the power module (30), and configured to receive heat from the heat rejection portion (21), wherein the cooling panel (22) is removably fixed to the surface of the heat rejection portion (21) opposite to the surface in contact with the power module (30) using screws; and
a pipe (23) fixed to a surface of the cooling panel (22) opposite to a surface in contact with the heat rejection portion (21), and configured to transfer heat from the cooling panel (22) to refrigerant circulating through the pipe (23),
the heat rejection portion (21) being mounted on the casing (40),
wherein the heat rejection portion (21) and the cooling panel (22) are separable from each other for service purposes, while the power module (30) remains fixed to the heat rejection portion (21).

2. The power conversion device (20) of claim 1, wherein the heat rejection portion (21) comprises a heat rejection panel independent of the casing (40).

3. The power conversion device (20) of claim 2, wherein the cooling panel (22) has a size equal to or larger than a size of the heat rejection portion (21).

4. The power conversion device (20) of claim 2 or 3, wherein the cooling panel (22) has the same size as a size of the heat rejection portion (21).

5. The power conversion device (20) of claim 1, wherein the heat rejection portion (21) is integrated with the casing (40).

6. The power conversion device (20) of any one of claims 1 to 5, further comprising an outer casing (42) covering the casing (40), the heat rejection portion (21), the cooling panel (22), and the pipe (23), and having a heat insulating material (42a) inside the outer casing (42).

7. The power conversion device (20) of any one of claims 1 to 6, further comprising an inner casing (41) provided inside the casing (40), and accommodating the power module (30) together with the casing (40).

8. The power conversion device (20) of any one of claims 1 to 7, wherein the pipe (23) protrudes from a rim portion of the cooling panel (22).

9. The power conversion device (20) of any one of claims 1 to 8, wherein the heat rejection portion (21) has a thermal resistance larger than a thermal resistance of the cooling panel (22).

10. The power conversion device (20) of any one of claims 1 to 9, further comprising:
a first heat transfer member (24) interposed between the power module (30) and the heat rejection portion (21); and
a second heat transfer member (25) interposed between the heat rejection portion (21) and the cooling panel (22),
wherein the first heat transfer member (24) has a thermal resistance larger than a thermal resistance of the second heat transfer member (25).

11. The power conversion device (20) of any one of claims 1 to 9, further comprising:
a first heat transfer member (24) interposed between the power module (30) and the heat rejection portion (21); and
a second heat transfer member (25) interposed between the heat rejection portion (21) and the cooling panel (22),
wherein the first heat transfer member (24) has a thermal resistance smaller than a thermal resistance of the second heat transfer member (25).

12. A refrigeration cycle apparatus, comprising:
a refrigerant circuit (3) through which the refrigerant circulates, the refrigerant circuit (3) including a compressor (4), a first heat exchanger (6), a first expansion device (7a), a second expansion device (7b), and a second heat exchanger (8) connected by a refrigerant pipe (3a); and
the power conversion device (20) of any one of claims 1 to 11 comprising the pipe (23) into which the refrigerant circulating between the first expansion device (7a) and the second expansion device (7b) flows.

13. The refrigeration cycle apparatus of claim 12, further comprising a bypass circuit (10) in which a point between the first expansion device (7a) and the second expansion device (7b), and a suction side of the compressor (4) are connected to each other by a bypass pipe (10a),
wherein the pipe (23) of the power conversion device (20) is connected to the bypass pipe (10a) of the bypass circuit (10).

14. The refrigeration cycle apparatus of claim 12, wherein the pipe (23) of the power conversion device (20) is connected to the refrigerant pipe (3a) connecting the first expansion device (7a) and the second expansion device (7b) to each other.

## Patentansprüche

1. Energieumwandlungsvorrichtung (20) umfassend:
ein Leistungsmodul (30) mit einer Wärmeabgabefläche (30a);
eine Platine (31), die mit dem Leistungsmodul (30) durch einen Verbindungsabschnitt (32) verbunden ist und auf einer Flächenseite entgegengesetzt zur Wärmeabgabefläche (30a) des Leistungsmoduls (30) vorgesehen ist;
ein Gehäuse (40), das das Leistungsmodul (30) aufnimmt;
ein Wärmeableitungsteil (21), das an der Wärmeabgabefläche (30a) des Leistungsmoduls (30) befestigt und ausgebildet ist, Wärme vom Leistungsmodul (30) aufzunehmen;
eine Kühlplatte (22), die abnehmbar an einer Fläche des Wärmeableitungsteils (21) entgegengesetzt zu einer Fläche in Kontakt mit dem Leistungsmodul (30) befestigt ist und ausgebildet ist, Wärme von dem Wärmeableitungsteil (21) aufzunehmen, wobei die Kühlplatte (22) abnehmbar an der Fläche des Wärmeableitungsteils (21) entgegengesetzt zu der Fläche in Kontakt mit dem Leistungsmodul (30) unter Verwendung von Schrauben befestigt ist; und
ein Rohr (23), das an einer Fläche der Kühlplatte (22) entgegengesetzt zu einer Fläche in Kontakt mit dem Wärmeableitungsteil (21) befestigt und ausgebildet ist, Wärme von der Kühlplatte (22) an das durch das Rohr (23) umlaufende Kältemittel zu übertragen,
wobei das Wärmeableitungsteil (21) auf dem Gehäuse (40) montiert ist,
wobei das Wärmeableitungsteil (21) und die Kühlplatte (22) zu Wartungszwecken voneinander trennbar sind, während das Leistungsmodul (30) an dem Wärmeableitungsteil (21) befestigt bleibt.

2. Energieumwandlungsvorrichtung (20) nach Anspruch 1, wobei das Wärmeableitungsteil (21) eine vom Gehäuse (40) unabhängige Wärmeabfuhrplatte umfasst.

3. Energieumwandlungsvorrichtung (20) nach Anspruch 2, wobei die Kühlplatte (22) eine Größe hat, die gleich oder größer ist als die Größe des Wärmeableitungsteils (21).

4. Energieumwandlungsvorrichtung (20) nach Anspruch 2 oder 3, wobei die Kühlplatte (22) die gleiche Größe wie das Wärmeableitungsteil (21) aufweist.

5. Energieumwandlungsvorrichtung (20) nach Anspruch 1, wobei das Wärmeableitungsteil (21) in das Gehäuse (40) eingebunden ist.

6. Energieumwandlungsvorrichtung (20) nach einem der Ansprüche 1 bis 5, die ferner ein äußeres Gehäuse (42) umfasst, das das Gehäuse (40), das Wärmeableitungsteil (21), die Kühlplatte (22) und das Rohr (23) bedeckt und ein wärmeisolierendes Material (42a) innerhalb des äußeren Gehäuses (42) aufweist.

7. Energieumwandlungsvorrichtung (20) nach einem der Ansprüche 1 bis 6, die ferner ein inneres Gehäuse (41) umfasst, das im Inneren des Gehäuses (40) vorgesehen ist und das Leistungsmodul (30) zusammen mit dem Gehäuse (40) aufnimmt.

8. Energieumwandlungsvorrichtung (20) nach einem der Ansprüche 1 bis 7, wobei das Rohr (23) aus einem Randbereich der Kühlplatte (22) herausragt.

9. Energieumwandlungsvorrichtung (20) nach einem der Ansprüche 1 bis 8, wobei das Wärmeableitungsteil (21) einen Wärmewiderstand aufweist, der größer ist als der Wärmewiderstand der Kühlplatte (22).

10. Energieumwandlungsvorrichtung (20) nach einem der Ansprüche 1 bis 9, ferner umfassend:
ein erstes Wärmeübertragungselement (24), das zwischen dem Leistungsmodul (30) und dem Wärmeableitungsteil (21) angeordnet ist; und
ein zweites Wärmeübertragungselement (25), das zwischen dem Wärmeableitungsteil (21) und der Kühlplatte (22) angeordnet ist,
wobei das erste Wärmeübertragungselement (24) einen Wärmewiderstand aufweist, der größer ist als der Wärmewiderstand des zweiten Wärmeübertragungselements (25).

11. Energieumwandlungsvorrichtung (20) nach einem der Ansprüche 1 bis 9, ferner umfassend:
ein erstes Wärmeübertragungselement (24), das zwischen dem Leistungsmodul (30) und dem Wärmeableitungsteil (21) angeordnet ist; und
ein zweites Wärmeübertragungselement (25), das zwischen dem Wärmeableitungsteil (21) und der Kühlplatte (22) angeordnet ist,
wobei das erste Wärmeübertragungselement (24) einen Wärmewiderstand aufweist, der kleiner ist als der Wärmewiderstand des zweiten Wärmeübertragungselements (25).

12. Kühlkreislaufvorrichtung, umfassend:
einen ersten Kältemittelkreis (3), durch den ein Kältemittel umläuft, wobei der Kältemittelkreis (3) einen ersten Verdichter (4), einen ersten Wärmetauscher (6), eine erste Expansionsvorrichtung (7a), eine zweite Expansionsvorrichtung (7b) und einen zweiten Wärmetauscher (8) umfasst, die durch eine Kältemittelleitung (3a) verbunden sind; und
die Energieumwandlungsvorrichtung (20) nach einem der Ansprüche 1 bis 11, die die Leitung (23) umfasst, in der das zwischen der ersten Expansionsvorrichtung (7a) und der zweiten Expansionsvorrichtung (7b) umlaufende Kältemittel fließt.

13. Kühlkreislaufvorrichtung nach Anspruch 12, außerdem einen Bypasskreis (10) umfassend, in dem ein Punkt zwischen der ersten Expansionsvorrichtung (7a) und der zweiten Expansionsvorrichtung (7b) und eine Saugseite des Verdichters (4) durch eine Bypassleitung (10a) miteinander verbunden sind,
wobei die Leitung (23) der Energieumwandlungsvorrichtung (20) mit der Bypassleitung (10a) des Bypasskreises (10) verbunden ist.

14. Kühlkreislaufvorrichtung nach Anspruch 12, wobei das Rohr (23) der Energieumwandlungsvorrichtung (20) mit dem Kältemittelrohr (3a) verbunden ist, das die erste Expansionsvorrichtung (7a) und die zweite Expansionsvorrichtung (7b) miteinander verbindet.

## Revendications

1. Un dispositif de conversion de puissance (20), comprenant :
un module d'alimentation (30) ayant une surface de rejet de chaleur (30a) ;
une carte (31) reliée au module d'alimentation (30) par une partie de liaison (32), et prévue sur un côté de surface opposé à la surface de rejet de chaleur (30a) du module d'alimentation (30) ;
un boîtier (40) accueillant le module d'alimentation (30) ;
une partie de rejet de chaleur (21) fixée à la surface de rejet de chaleur (30a) du module d'alimentation (30), et conçue pour recevoir de la chaleur émanant du module d'alimentation (30) ;
un panneau de refroidissement (22) fixé de manière amovible à une surface de la partie de rejet de chaleur (21) opposée à une surface en contact avec le module d'alimentation (30), et conçu pour recevoir de la chaleur émanant de la partie de rejet de chaleur (21), dans lequel le panneau de refroidissement (22) est fixé de manière amovible à la surface de la partie de rejet de chaleur (21) opposée à la surface en contact avec le module d'alimentation (30) à l'aide de vis ; et
un tuyau (23) fixé à une surface du panneau de refroidissement (22) opposée à une surface en contact avec la partie de rejet de chaleur (21), et conçu pour transférer de la chaleur émanant du panneau de refroidissement (22) au fluide frigorigène circulant dans le tuyau (23),
la partie de rejet de chaleur (21) étant montée sur le boîtier (40),
dans lequel la partie de rejet de chaleur (21) et le panneau de refroidissement (22) sont séparables l'un de l'autre à des fins de maintenance, tandis que le module d'alimentation (30) reste fixé à la partie de rejet de chaleur (21).

2. Le dispositif de conversion de puissance (20) de la revendication 1, dans lequel la partie de rejet de chaleur (21) comprend un panneau de rejet de chaleur indépendant du boîtier (40).

3. Le dispositif de conversion de puissance (20) de la revendication 2, dans lequel la taille du panneau de refroidissement (22) est supérieure ou égale à la taille de la partie de rejet de chaleur (21).

4. Le dispositif de conversion de puissance (20) de la revendication 2 ou 3, dans lequel la taille du panneau de refroidissement (22) est égale à la taille de la partie de rejet de chaleur (21).

5. Le dispositif de conversion de puissance (20) de la revendication 1, dans lequel la partie de rejet de chaleur (21) est intégrée au boîtier (40).

6. Le dispositif de conversion de puissance (20) de l'une quelconque des revendications 1 à 5, comprenant en outre un boîtier extérieur (42) recouvrant le boîtier (40), la partie de rejet de chaleur (21), le panneau de refroidissement (22), et le tuyau (23), et l'intérieur du boîtier extérieur (42) étant garni d'un matériau d'isolation thermique (42a).

7. Le dispositif de conversion de puissance (20) de l'une quelconque des revendications 1 à 6, comprenant en outre un boîtier intérieur (41) prévu dans le boîtier (40), et accueillant le module d'alimentation (30) conjointement avec le boîtier (40).

8. Le dispositif de conversion de puissance (20) de l'une quelconque des revendications 1 à 7, dans lequel le tuyau (23) dépasse d'une partie de bord du panneau de refroidissement (22).

9. Le dispositif de conversion de puissance (20) de l'une quelconque des revendications 1 à 8, dans lequel la résistance thermique de la partie de rejet de chaleur (21) est supérieure à la résistance thermique du panneau de refroidissement (22).

10. Le dispositif de conversion de puissance (20) de l'une quelconque des revendications 1 à 9, comprenant en outre :
un premier élément de transfert de chaleur (24) interposé entre le module d'alimentation (30) et la partie de rejet de chaleur (21) ; et
un second élément de transfert de chaleur (25) interposé entre la partie de rejet de chaleur (21) et le panneau de refroidissement (22),
dans lequel la résistance thermique du premier élément de transfert de chaleur (24) est supérieure à la résistance thermique du second élément de transfert de chaleur (25).

11. Le dispositif de conversion de puissance (20) de l'une quelconque des revendications 1 à 9, comprenant en outre :
un premier élément de transfert de chaleur (24) interposé entre le module d'alimentation (30) et la partie de rejet de chaleur (21) ; et
un second élément de transfert de chaleur (25) interposé entre la partie de rejet de chaleur (21) et le panneau de refroidissement (22),
dans lequel la résistance thermique du premier élément de transfert de chaleur (24) est inférieure à la résistance thermique du second élément de transfert de chaleur (25).

12. Un appareil à cycle de réfrigération comprenant :
un circuit de fluide frigorigène (3) dans lequel circule le fluide frigorigène, le circuit de fluide frigorigène (3) comprenant un compresseur (4), un premier échangeur de chaleur (6), un premier dispositif d'expansion (7a), un second dispositif d'expansion (7b), et un second échangeur de chaleur (8) reliés par un tuyau de fluide frigorigène (3a) ; et
le dispositif de conversion de puissance (20) de l'une quelconque des revendications 1 à 11 comprenant le tuyau (23) dans lequel s'écoule le fluide frigorigène circulant entre le premier dispositif d'expansion (7a) et le second dispositif d'expansion (7b).

13. L'appareil à cycle de réfrigération de la revendication 12, comprenant en outre un circuit de dérivation (10) dans lequel un point situé entre le premier dispositif d'expansion (7a) et le second dispositif d'expansion (7b), et un côté aspiration du compresseur (4) sont reliés l'un à l'autre par un tuyau de dérivation (10a),
dans lequel le tuyau (23) du dispositif de conversion de puissance (20) est relié au tuyau de dérivation (10a) du circuit de dérivation (10).

14. L'appareil à cycle de réfrigération de la revendication 12, dans lequel le tuyau (23) du dispositif de conversion de puissance (20) est relié au tuyau de fluide frigorigène (3a) reliant l'un à l'autre le premier dispositif d'expansion (7a) et le second dispositif d'expansion (7b).
